# EUROPÄISCHE PATENTSCHRIFT

(11) **EP 1 243 843 B1**
(45) Veröffentlichungstag und Bekanntmachung des Hinweises auf die Patenterteilung: **31.12.2008**
(21) Anmeldenummer: 02090004.9
(22) Anmeldetag: 08.01.2002
(51) Int. Cl.: F21S 8/00, F21V 29/00, H01L 33/00, F21Y 101/02

(54) **LED-Signalmodul**
LED signal module
Module de signalisation à diodes électroluminescentes

(30) Priorität: 19.01.2001 DE 10102353
(43) Veröffentlichungstag der Anmeldung: 25.09.2002
(73) Patentinhaber: SIEMENS AKTIENGESELLSCHAFT, 80333 München (DE); OSRAM Opto Semiconductors GmbH, 93055 Regensburg (DE)
(72) Erfinder: Bluemel, Simon, 84069 Schierling (DE); Heilmann, Axel, 14974 Genshagen (DE); Kreplin, Ulrich, 16321 Schoenow (DE); Zabel, Michael, 12679 Berlin (DE); Zimmermann, Dirk, 13053 Berlin (DE)

(56) Entgegenhaltungen:
- WO-A-99/11107
- DE-A- 19 528 459
- US-A- 4 733 335
- US-A- 5 612 680
- US-A- 5 785 418
- US-A- 5 808 592
- US-A- 5 857 767
- PATENT ABSTRACTS OF JAPAN vol. 1995, no. 08, 29. September 1995 (1995-09-29) -& JP 07 114813 A (KOITO MFG CO LTD), 2. Mai 1995 (1995-05-02)

## Beschreibung

Die vorliegende Erfindung bezieht sich auf ein LED-Signalmodul, bei dem insbesondere die LED-Bauelemente zumindest staubdicht und bevorzugt auch wasserdicht verkapselt sind.

Leuchtdioden, im Folgenden kurz LEDs genannt, kommen in zunehmendem Maße in Straßenverkehrs- und Eisenbahn-Leuchtsignalen zum Einsatz. Die LED-Signalmodule, die in der Regel an Stelle von herkömmlichen Leuchtmitteln eine Mehrzahl von LED-Bauelementen als Leuchtmittel enthalten, sind am Einsatzort extremen und aggressiven klimatischen, chemischen, biologischen und mechanischen Umweltbedingungen ausgesetzt und müssen gegen eine Beeinträchtigung durch diese unfreundlichen Bedingungen geschützt sein.

Signalisierungseinrichtungen auf der Basis von LEDs müssen auf die Eigenschaften dieser Leuchtmittel abgestimmt sein. So gibt es Einflüsse, welche bei Verwendung herkömmlicher Signallampen und -leuchtmittel, wie Glübirnen oder Propanleuchten, unkritisch sind, aber bei Verwendung von LEDs als Leuchtmittel von funktionsbestimmender Bedeutung sind. Schon bei der Vorsorge gegen oder Beseitigung von Verschmutzungen durch Staub und Ähnlichem ergeben sich Unterschiede. So lassen sich bei herkömmlichen Signalgebern die Komponenten, die Einfluß auf die Lichtstärke haben, wie beispielsweise die Lampe, die Abschlussscheibe und der Farbfilter, vergleichsweise problemlos mechanisch durch Abwischen reinigen. In LED-Signalmodulen bilden die LEDs in der Regel zusammen mit abbildenden optischen Bauelementen ein optisches System, dessen Einzelteile für Reinigungsmaßnahmen nur schwer zugänglich oder dagegen gar empfindlich sind.

Eine weitere Einflußgröße ist die Wärmeableitung von den LEDs, deren Lebensdauer von der Chiptemperatur im Betrieb beeinflußt ist. Je besser die Wärmeableitung, umso größer die Lebensdauer der LEDs.

Bei einem aus der US-A-5,785,418 bekannten LED-Signalmodul ist an einer ersten Hauptfläche einer elektrisch isolierenden Leiterplatte eine Mehrzahl von LED-Bauelementen und an einer der ersten Hauptfläche gegenüberliegenden zweiten Hauptfläche der Leiterplatte eine Kühleinrichtung zur Kühlung der LED-Bauelemente angeordnet. Leiterbahnen zur Verschaltung der LED-Bauelemente sind mittels einer Mehrzahl von staubdichten, wärmeleitenden Durchführungen durch die Leiterplatte von der ersten Hauptfläche zur zweiten Hauptfläche thermisch leitend durchkontaktiert. Die wärmeleitenden Durchführungen sind mit der Kühleinrichtung wärmeleitend verbunden.

Der vorliegenden Erfindung liegt die Aufgabe zugrunde, ein LED-Signalmodul zur Verfügung zu stellen, das gegen schädigende Umgebungseinflüsse ausreichend geschützt ist. Weiterhin soll ein solches Modul eine möglichst geringe thermische Belastung der LED-Bauelemente aufweisen.

Die Aufgabe wird durch ein LED-Signalmodul mit den Merkmalen des Patentanspruches 1 oder 2 gelöst.

Bei einem LED-Signalmodul, bei dem an einer ersten Hauptfläche einer elektrisch isolierenden Leiterplatte eine Mehrzahl von LED-Bauelementen und an einer der ersten Hauptfläche gegenüberliegenden zweiten Hauptfläche der Leiterplatte eine Kühleinrichtung angeordnet ist, bei dem weiterhin auf der ersten Hauptfläche angeordnete, insbesondere zur Verschaltung der LED-Bauelemente vorgesehene Leiterbahnen mittels einer Mehrzahl von staubdichten, wärmeleitenden Durchführungen durch die Leiterplatte mit der zweiten Hauptfläche der Leiterplatte wärmeleitend verbunden sind, wobei die wärmeleitenden Durchführungen mit der Kühleinrichtung wärmeleitend verbunden sind, ist erfindungsgemäß vorgesehen, dass an der zweiten Hauptfläche der Leiterplatte eine Buchsenleiste angeordnet ist, deren elektrische Anschlusskontakte mittels staubdichter, elektrisch leitender Durchführungen mit den auf der ersten Hauptfläche angeordneten elektrischen Leiterbahnen verbunden sind.

Bei einem weiteren LED-Signalmodul, bei dem an einer ersten Hauptfläche einer Metallkern-Leiterplatte eine Mehrzahl von LED-Bauelementen und eine Leiterbahnstruktur zur Verschaltung der LED-Bauelemente angeordnet ist und bei dem an einer der ersten Hauptfläche gegenüberliegenden zweiten Hauptfläche der Metallkern-Leiterplatte eine Kühleinrichtung angeordnet ist, weist die Metallkern-Leiterplatte erfindungsgemäß im Bereich von Anschlusskontakten einer Buchsenleiste, die an der ersten Hauptfläche angeordnet ist, einen oder mehrere Durchbrüche auf, durch den bzw. die die Buchsenleiste für eine Steckerleiste von der zweiten Hauptfläche her zugänglich ist, wobei die Buchsenleiste mittels einer Dichtungsschicht staubdicht von dem Bereich, in dem sich die LED-Bauelemente befinden, abgetrennt ist.

Eine geringe thermische Belastung der LED-Bauelemente, das heißt eine geringe Temperaturerhöhung der LED-Bauelemente im Betrieb des Moduls wird vorteilhafterweise dadurch erreicht, dass sich auf der Leiterplatte als Wärmequellen im Wesentlichen nur die LED-Bauelemente befinden und diese zudem mittels einer Kühleinrichtung, zum Beispiel ein Metall-Kühlkörper bekannter Art, die in thermischem Kontakt mit Leiterbahnen zur Verschaltung der LED-Bauelemente bzw. mit der Metallkern-Leiterplatte steht. Weitere verlustwärmeproduzierende Bauelemente, insbesondere einer Energieversorgungs- und/oder Steuereinrichtung, sind weitestgehend entfernt von der Leiterplatte angeordnet.

Vorteilhafte Weiterbildungen und bevorzugte Ausführungsformen des Moduls ergeben sich aus den im Folgenden in Verbindung mit den Figuren 1 bis 5 beschriebenen Ausführungsbeispielen.
Es zeigen:
Figur 1, eine schematische Schnittdarstellung eines ersten Ausführungsbeispieles;
Figur 2, eine schematische Schnittdarstellung eines zweiten Ausführungsbeispieles;
Figur 3, eine schematische Schnittdarstellung eines LED-Signalmoduls gemäß einer bevorzugten Weiterbildung;
Figur 4, eine schematische Schnittdarstellung einer bevorzugten Ausgestaltung der Gehäuseabdichtung des LED-Signalmoduls; und
Figur 5, eine schematische Darstellung der Rückseite des Signalmoduls gemäß dem Ausführungsbeispiel.

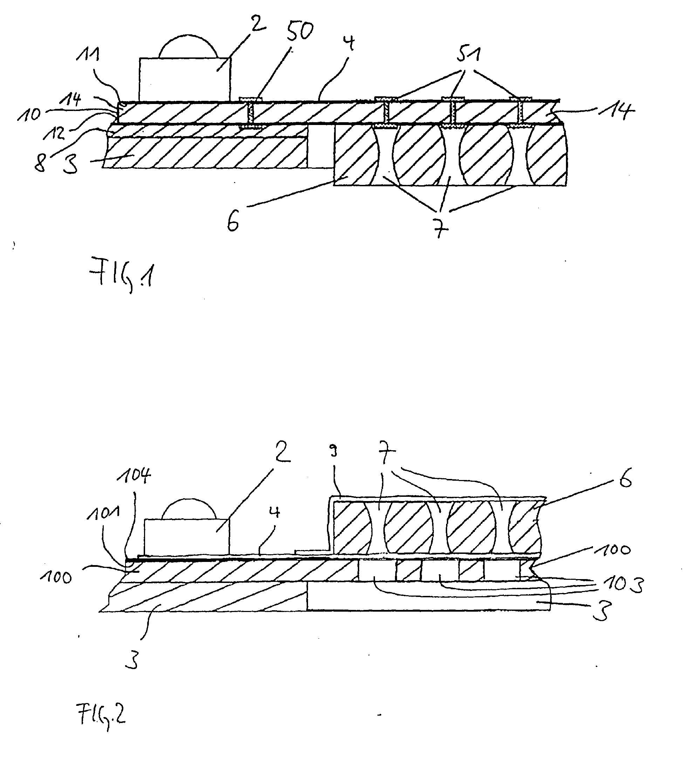

Bei dem Ausführungsbeispiel von Figur 1 ist eine Leiterplatte 10 vorgesehen, die eine elektrisch isolierende Trägerplatte 14 aufweist. Auf einer ersten Hauptfläche 11 der Trägerplatte 14 ist eine elektrische Leiterbahnstruktur 4 aufgebracht, die zur Verschaltung und elektrischen Stromversorgung für eine Mehrzahl von auf die erste Hauptfläche motierten LED-Bauelementen 2 dient.

Die LED-Bauelemente 2 weisen vorzugsweise eine oberflächenmontierbare LED-Bauform auf. Es können aber auch Radialbauformen von LED-Bauelementen verwendet werden, die in Durchsteckmontage auf der Leiterplatte 10 befestigt sind. Ebenso ist eine sogenannte Chip-on-Board-Montage denkbar, bei der ungehäuste LED-Chips unmittelbar auf die Leiterplatte 10 montiert werden.

An einer der ersten Hauptfläche 11 gegenüberliegenden zweiten Hauptfläche 12 der Leiterplatte 10 ist eine Kühleinrichtung 3, beispielsweise ein herkömmlicher metallischer Kühlkörper mit Kühllamellen, angeordnet. Diese ist mit den elektrischen Leiterbahnen 4 über zumindest staubdichte, bevorzugt auch wasserdichte wärmeleitende Durchführungen 50 und einer elektrisch isolierenden Wärmeleitfolie 8 verbunden.

Die wärmeleitenden Durchführungen 50, die beispielsweise aus metallischem Material gefertigt sind, und die Wärmeleitfolie 8, beispielsweise eine kommerziell erhältliche Folie mit der Bezeichnung HI-FLOW^{™} 625 der Firma Bergquist, gewährleisten vorteilhafterweise eine gute Ableitung der im Betrieb der LED-Bauelemente von diesen erzeugten Verlustwärme, wodurch die Temperaturerhöhung der LED-Bauelemente im Betrieb und damit die Alterung der LED-Bauelemente so weit wie möglich verringert ist.

An der zweiten Hauptfläche 12 der Leiterplatte ist weiterhin eine Buchsenleiste 6 montiert. Die elektrischen Anschlußkontakte 7, beispielsweise Federkontakte für Stifte einer Stekkerleiste, sind mittels staubdichten elektrisch leitenden Durchführungenen 51 mit den auf der ersten Hauptfläche 11 angeordneten elektrischen Leiterbahnen 4 elektrisch verbunden.

Bei dem Ausführungsbeispiel von Figur 2 ist eine Metallkern-leiterplatte 100 vorgesehen, die mit einer elektrisch isolierenden Schicht 104 versehen ist. Auf der isolierenden Schicht 104 befindet sich, eine Mehrzahl von LED-Bauelementen 2, eine Buchsenleiste 6 und eine Leiterbahnstruktur 4 zur elektrischen Verschaltung der LED-Bauelemente 2 und der Buchsenleiste 6. Auf der der Isolierschicht 104 gegenüberliegenden Seite der Leiterplatte ist eine Kühleinrichtung 3 angeordnet, die vorzugsweise in direktem Kontakt mit dem Metallkern der Metallkernplatine 100 steht.

Die Metallkernplatine 100 weist im Bereich von Anschlußkontakten 7 der Buchsenleiste 6 mehrere Durchbrüche 103, zum Beispiel Bohrungen auf, über die die Federkontakte 7 der Buchsenleiste 6 für Kontaktstifte einer Steckerleiste von der Kühlkörperseite her zugänglich ist. Die Buchsenleiste 6 ist mittels einer Dichtungsschicht 9, zum Beispiel ein Kunststoff-Verguß, staubdicht von dem Bereich, in dem sich die LED-Bauelemente 2 befinden, abgetrennt.

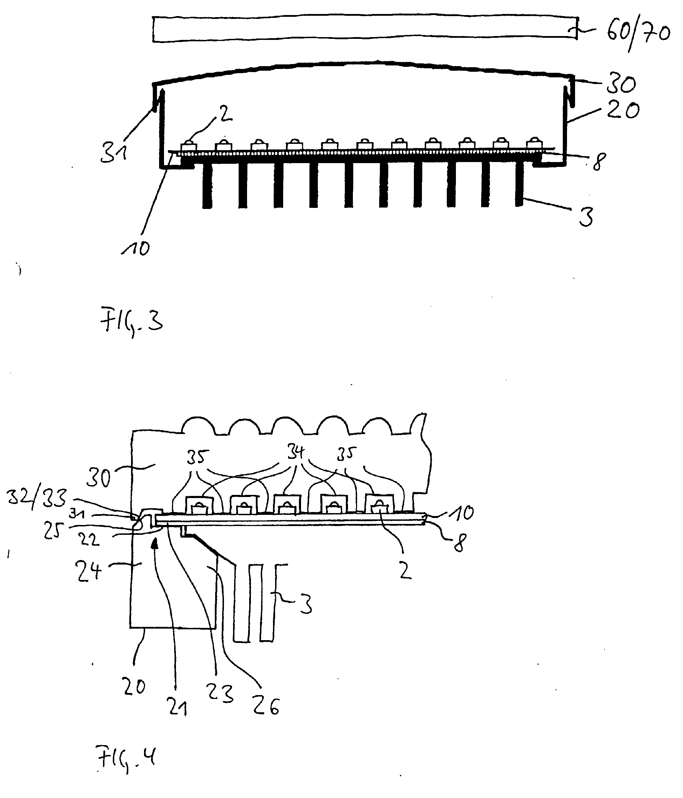

Bei der schematischen Schnittansicht gemäß Figur 3 ist prinzipiell gezeigt, wie eine Anordnung gemäß Figur 1 oder 2 in einem Modulgehäuse angeordnet ist. Die Leiterplatte 10 bzw. 100 mit den LED-Bauelementen 2, der Buchsenleiste 6 und dem Kühlkörper 3 befindet sich in einem Modulträger 20. Zwischen Modulträger 20 und Leiterplatte 10, 100 ist eine staubdichte Verbindung ausgebildet. Auf einer umlaufenden Seitenwand des Modulträgers 20 ist eine Optikplatte 30, beispielsweise ein Linsenträger, aufgesetzt, die die LED-Bauelemente 2 überspannt. Der Randbereich der Optikplatte 30 bildet mit der umlaufenden Seitenwand des Modulträgers 20 eine staubdichte Verbindung aus, so daß das Innere des Baugruppengehäuses, das im Wesentlichen von der Leiterplatte 10,100, dem Modulträger 20 und der Optikplatte 30 gebildet ist, staubdicht von der Umgebung abgetrennt ist.

Der Modulträger und die Optikplatte bestehen vorzugsweise beide aus transparentem Kunststoff, wodurch das im Betrieb entstehende Streulicht der LEDs zu einer verbesserten Seitensichtbarkeit des Signals führt.

Vorzugsweise ist über der Optikplatte 30 ein Abschlussglas 60 und/oder eine Streuscheibe 70 angeordnet, wodurch vorteilhafterweise eine Reduzierung von einfallendem UV-Strahlung erzielt wird, die zu einer beschleunigten Degradation der LED-Bauelemente führen würde.

In Figur 4 ist ein detaillierter Ausschnitt einer bevorzugten Ausführungsfrom der Gehäuseabdichtung schematisch dargestellt. Ein Modulträger 20, der hier im Wesentlichen die Form eines um die Leiterplatte 10 umlaufenden Trägerringes oder - rahmens aufweist, ist an der Stirnfläche seiner umlaufenden Seitenwand 24 mit einem Falz 21 versehen, auf dessen Auflagefläche 22 die Leiterplatte 10 aufgelegt ist. Zwischen der Leiterplatte 10 und der Auflagefläche auf der Seitenwand 24 befindet sich der Rand der Wärmeleitfolie 8, die an dieser Stelle die Funktion einer Dichtungsschicht erfüllt.

Auf, der Leiterplatte 10 liegt in Bereichen zwischen den LED-Bauelementen 2 die Optikpatte 30, beispielsweise eine Linsenplatte, auf, die mit dem Modulträger 20 beispielsweise verschraubt ist und dadurch den Rand der Leiterplatte auf die Seitenwand 24 des Modulträgers 20 presst. Die LED-Bauelemente 2 finden in Ausnehmungen 34 der Optikplatte 30 Platz.

Weiterhin besitzt die Optikplatte eine am äußeren Rand umlaufende Wulst 31, die sich ausgehend von der dem Modulträger 20 zugewandten Unterseite der Optikplatte in Richtung des Modulträgers 20 erstreckt und über den gesamten Umfang über die Seitenwand 24 greift und mit dieser teilweise überlappt.

Sowohl die auf die Seitenwand 24 aufliegende Innenseite der Wulst 31 als auch die entsprechende Auflagefläche der Seitenwand 24, weisen je eine Abschrägung 25, 33 auf, so daß ein sicheres "Einrasten" des Modulträgers 20 in die Optikplatte 30 möglich ist und gleichzeitig eine staubdichte Verbindung erzeugt wird. Die Abschrägung 25 der Seitenwand 24 ist dazu besonders bevorzugt weniger steil als die Abschrägung 33 der Wulst 31.

Selbstverständlich kann umgekehrt auch der Modulträger 20 eine umlaufende Wulst aufweisen, die dann über die äußere Seitenwand der Optikplatte 30 greift.

Schließlich weist der Modulträger 20 ein Aufnahmeelement 26 für den Kühlkörper 3 auf, mit dem der Kühlkörper 3 gegen die Wärmeleitfolie 8 gedrückt ist.

In dem Modul liegen Teilbereiche 35 der der Leiterplatte 10 zugewandten Seite der Optikplatte 30 zwischen den LED-Bauelementen 2 auf der ersten Hauptfläche 11 der Leiterplatte 10 auf und drücken die Leiterplatte 10 gegen den Falz 21 des Modulträgers 20.

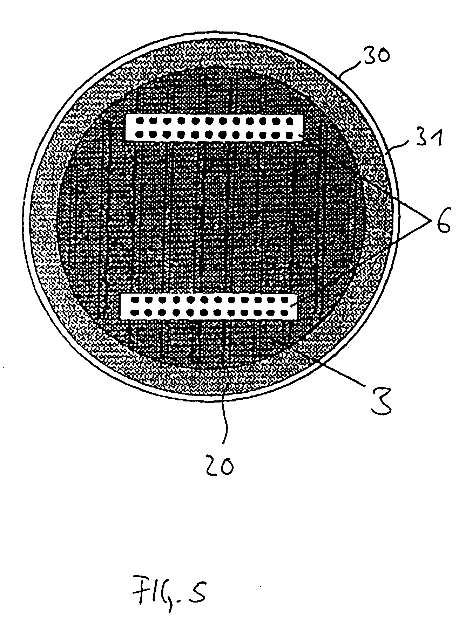

Die Figur 5 zeigt eine schematische Darstellung Ansicht der Rückseite einer fertig montierten Baugruppe, in der der Kühlkörper 3 mit Aussparungen für zwei Buchsenleisten 6, die Unterseite der umlaufenden Seitendwand 24 des Modulträgers 20 und die Wulst 31 der Optikplatte 30 zu erkennen sind.

Die Buchsenleisten 6 dienen zur Verbindung der LED-Bauelemente 2 mit extern angeordneten elektronischen Bauelementen zu deren Ansteuerung. Auf der Leiterplatte sind besonders bevorzugt nur die LED-Bauelemente 2 und die Buchsenleisten 6 montiert, so daß keine zusätzliche Verlustwärme in der Nähe der LED-Bauelemente durch Ansteuerelektronik entsteht. Weiterhin erlaubt diese Anordnung vorteilhafterweise einen getrennten Austausch von LED-Signallampe und Ansteuerelektronik.

## Patentansprüche

1. LED-Signalmodul, bei dem
- an einer ersten Hauptfläche (11) einer elektrisch isolierenden Leiterplatte (10) eine Mehrzahl von LED-Bauelementen (2) und an einer der ersten Hauptfläche (11) gegenüberliegenden zweiten Hauptfläche (12) der Leiterplatte (10) eine Kühleinrichtung (3) angeordnet ist,
- auf der ersten Hauptfläche (11) angeordnete, insbesondere zur Verschaltung der LED-Bauelemente (2) vorgesehene Leiterbahnen (4) mittels einer Mehrzahl von staubdichten wärmeleitenden Durchführungen (50) durch die Leiterplatte (10) mit der zweiten Hauptfläche (12) der Leiterplatte (10) wärmeleitend verbunden sind und
- die wärmeleitenden Durchführungen (50) mit der Kühleinrichtung (3) wärmeleitend verbunden sind
**dadurch gekennzeichnet, dass**
an der zweiten Hauptfläche (12) der Leiterplatte (10) eine Buchsenleiste (6) angeordnet ist, deren elektrische Anschlußkontakte (7) mittels staubdichter, elektrisch leitender Durchführungen (51) mit den auf der ersten Hauptfläche (11) angeordneten elektrischen Leiterbahnen (4) verbunden sind.

2. LED-Signalmodul, bei dem
- an einer ersten Hauptfläche (101) einer Metallkern-Leiterplatte (100) eine Mehrzahl von LED-Bauelementen (2) und eine Leiterbahnstruktur (4) zur Verschaltung der LED-Bauelemente (2) angeordnet ist und
- an einer der ersten Hauptfläche (101) gegenüberliegenden zweiten Hauptfläche (102) der Metallkern-Leiterplatte (100) eine Kühleinrichtung (3) angeordnet ist,
**dadurch gekennzeichnet, dass**
- die Metallkern-Leiterplatte (100) im Bereich von Anschlußkontakten (7) einer Buchsenleiste (6), die an der ersten Hauptfläche (101) angeordnet ist, einen oder mehrere Durchbrüche (103) aufweist, über den bzw. die die Buchsenleiste (6) für eine Steckerleiste von der zweiten Hauptfläche (102) der Metallkern-Leiterplatte (100) her zugänglich ist, und
- die Buchsenleiste (6) mittels einer Dichtungsschicht (9) staubdicht von dem Bereich, in dem sich die LED-Bauelemente (2) befinden, abgetrennt ist.

3. LED-Signalmodul nach Anspruch 1 bei dem zwischen der zweiten Hauptfläche (12) der Leiterplatte (10) und der Kühleinrichtung (3) eine elektrisch isolierende Wärmeleitfolie (8) angeordnet ist.

4. LED-Signalmodul nach einem der vorangehenden Ansprüche, bei der ein umlaufender Rand (13) der elektrischen Leiterplatte (10) in einen umlaufenden Falz (21) eines Modulträgers (20) eingepaßt ist und zwischen der Leiterplatte (10) und einer Auflagefläche (22) des Falzes (21) für die Leiterplatte (10) ein umlaufendes staubdichtes Dichtungselement (23) angeordnet ist.

5. LED-Signalmodul nach Anspruch 3 und 4, bei dem ein umlaufender Rand der Wärmeleitfolie (8) als umlaufendes Dichtungselement (23) genutzt ist.

6. LED-Signalmodul nach einem der vorangehenden Ansprüche, bei dem an der ersten Hauptfläche (11) der Leiterplatte (10) eine Optikplatte (30), insbesondere ein Linsenträger angeordnet ist, die auf einer um die Leiterplatte (10) umlaufenden Seitenwand (24) des Modulträgers (20) oder auf einem um die Mehrzahl von LED-Bauelementen (2) umlaufenden Rand der Leiterplatte (10) aufsitzt und mit dieser bzw. diesem eine staubdichte Gehäusedichtung aufweist.

7. LED-Signalmodul nach Anspruch 6, bei der die Optikplatte (30) eine über die Seitenwand (24) des Modulträgers (20) bzw. über die Stirnseite der Leiterplatte (10) greifende umlaufende Wulst (31) aufweist, die mit der Seitenwand (24) des Modulträgers (20) bzw. mit der Stirnseite der Leiterplatte (10) die staubdichte Gehäusedichtung (40) ausbildet.

8. LED-Signalmodul nach Anspruch, 7, bei dem sowohl die Seitenwand (24) des Modulträgers (20) bzw. die Stirnseite der Leiterplatte (10) als auch die umlaufende Innenseite (32) der Wulst (31) abgeschrägt ist, wobei die Schräge (33) der Wulst (31) steiler ist als die Schräge (25) der Seitenwand (24) des Modulträgers (20) bzw. der Stirnseite der Leiterplatte (10) und die beiden Schrägen (25,33) aufeinandergepresst sind und die staubdichte Gehäusedichtung (40) ausbilden.

9. LED-Signalmodul nach Anspruch 6, 7 oder 8, bei dem Teilbereiche (35) der der Leiterplatte (10) zugewandten Seite der Optikplatte (30) zwischen den LED-Bauelementen (2) auf der ersten Hauptfläche (11) der Leiterplatte (10) aufliegt und die Leiterplatte (10) gegen den Falz (21) des Modulträgers (20) drückt.

10. LED-Signalmodul nach einem der Ansprüche 6 bis 9, bei dem der Modulträger (20) und die Optikplatte (30) aus einem transparenten Kunststoffmaterial gefertigt ist.

11. LED-Signalmodul nach einem der Ansprüche 6 bis 10, bei dem der Optikplatte (30) in Abstrahlrichtung des Moduls ein Abschlußglas (60) nachgeordnet ist.

12. LED-Signalmodul nach einem der Ansprüche 6 bis 11, bei dem der Optikplatte (30) in Abstrahlrichtung des Moduls eine Streuscheibe (70) nachgeordnet ist.

13. LED-Signalmodul nach einem der vorangehenden Ansprüche, bei dem auf der Leiterplatte (10) im Wesentlichen nur die LED-Bauelemente (2) im Betrieb des Moduls wesentliche Verlustwärme produzieren und weitere verlustwärmeproduzierende Bauelemente, insbesondere einer Energieversorgungs- und/oder Steuereinrichtung, weitestgehend entfernt von der Leiterplatte (10) angeordnet sind.

## Claims

1. LED signal module in which
- a plurality of LED components (2) are arranged at a first main area (11) of an electrically insulating printed circuit board (10) and a cooling device (3) is arranged at a second main area (12) - opposite the first main area (11) - of the printed circuit board (10),
- conductor tracks (4) that are arranged on the first main area (11) and are provided in particular for the interconnection of the LED components (2) are thermally conductively connected to the second main area (12) of the printed circuit board (10) by means of a plurality of dust-tight thermally conductive feedthroughs (50) through the printed circuit board (10), and
- the thermally conductive feedthroughs (50) are thermally conductively connected to the cooling device (3),
**characterized in that**
a female connector strip (6) is arranged at the second main area (12) of the printed circuit board (10), the electrical connection contacts (7) of said female connector strip being connected, by means of dust-tight electrically conductive feedthroughs (51), to the electrical conductor tracks (4) arranged on the first main area (11).

2. LED signal module in which
- a plurality of LED components (2) and a conductor track structure (4) for interconnecting the LED components (2) are arranged at a first main area (101) of a metal core printed circuit board (100), and
- a cooling device (3) is arranged at a second main area (102) - opposite the first main area (101) - of the metal core printed circuit board (100),
**characterized in that**
- the metal core printed circuit board (100) has, in the region of connection contacts (7) of a female connector strip (6) arranged at the first main area (101), one or a plurality of perforations (103) via which the female connector strip (6) is accessible to a male connector strip from the second main area (102) of the metal core printed circuit board (100), and
- the female connector strip (6) is separated from the region in which the LED components (2) are situated in a dust-tight manner by means of a sealing layer (9).

3. LED signal module according to Claim 1, in which an electrically insulating heat-conducting film (8) is arranged between the second main area (12) of the printed circuit board (10) and the cooling device (3).

4. LED signal module according to any of the preceding claims, in which a circumferential edge (13) of the electrical printed circuit board (10) is fitted into a circumferential fold (21) of a module carrier (20) and a circumferential dust-tight sealing element (23) is arranged between the printed circuit board (10) and a bearing area (22) of the fold (21) for the printed circuit board (10).

5. LED signal module according to Claims 3 and 4, in which a circumferential edge of the heat-conducting film (8) is used as the circumferential sealing element (23).

6. LED signal module according to any of the preceding claims, in which there is arranged at the first main area (11) of the printed circuit board (10) an optical plate (30), in particular a lens carrier, which is seated on a side wall (24) of the module carrier (20) running around the printed circuit board (10) or on an edge of the printed circuit board (10) running around the plurality of LED components (2) and has a dust-tight housing seal with said side wall or said edge.

7. LED signal module according to Claim 6, in which the optical plate (30) has a circumferential bead (31) which reaches over the side wall (24) of the module carrier (20) or over the end side of the printed circuit board (10) and forms the dust-tight housing seal (40) with the side wall (24) of the module carrier (20) or with the end side of the printed circuit board (10).

8. LED signal module according to Claim 7, in which both the side wall (24) of the module carrier (20) or the end side of the printed circuit board (10) and the circumferential inner side (32) of the bead (31) are beveled, the bevel (33) of the bead (31) being steeper than the bevel (25) of the side wall (24) of the module carrier (20) or of the end side of the printed circuit board (10) and the two bevels (25, 33) being pressed onto one another and forming the dust-tight housing seal (40).

9. LED signal module according to Claim 6, 7 or 8, in which partial regions (35) of that side of the optical plate (30) which faces the printed circuit board (10), between the LED components (2), bear on the first main area (11) of the printed circuit board (10) and press the printed circuit board (10) against the fold (21) of the module carrier (20).

10. LED signal module according to any of Claims 6 to 9, in which the module carrier (20) and the optical plate (30) are produced from a transparent plastic material.

11. LED signal module according to any of Claims 6 to 10, in which a terminating glass (60) is disposed downstream of the optical plate (30) in the emission direction of the module.

12. LED signal module according to any of Claims 6 to 11, in which a diffusing screen (70) is disposed downstream of the optical plate (30) in the emission direction of the module.

13. LED signal module according to any of the preceding claims, in which, on the printed circuit board (10), essentially only the LED components (2) produce significant heat loss during operation of the module and further heat-loss-producing components, in particular of a power supply and/or control device, are arranged as distantly as possible from the printed circuit board (10).

## Revendications

1. Module de signalisation à DEL,
dans lequel
- sur une première surface ( 11 ) principale d'une plaquette ( 10 ) à circuit imprimé isolante électriquement est disposée une multiplicité de composants ( 2 ) à DEL et sur une deuxième surface ( 12 ) principale, opposée à la première surface ( 11 ) principale, de la plaquette ( 10 ) à circuit imprimé est disposé un dispositif ( 3 ) de refroidissement,
- des pistes ( 4 ) conductrices disposées sur la première surface ( 11 ) principale notamment pour le câblage des composants à DEL, sont reliées d'une manière conductrice de la chaleur, au moyen d'une multiplicité de traversées ( 50 ) conductrices de la chaleur et étanches à la poussière passant à travers la plaquette ( 10 ) à circuit imprimé à la deuxième surface ( 12 ) principale de la plaquette ( 10 ) à circuit imprimé et
- les traversées ( 50 ) conductrices de la chaleur sont reliées d'une manière conductrice de la chaleur au dispositif ( 3 ) de refroidissement,
**caractérisé en ce qu'**il est disposé sur la deuxième surface ( 12 ) principale de la plaquette ( 10 ) à circuit imprimé une réglette ( 6 ) de raccordement, dont les contacts ( 7 ) électriques de connexion sont reliés au moyen de traversées ( 51 ) étanches à la poussière et conductrices de l'électricité aux pistes ( 4 ) conductrices électriques disposées sur la première surface ( 11 ) principale.

2. Module de signalisation à DEL, dans lequel
- sur une première surface ( 101 ) principale d'une plaquette ( 100 ) à circuit imprimé à âme métallique est disposée une multiplicité de composants ( 2 ) à DEL et une structure ( 4 ) de pistes conductrices pour le câblage des composants ( 2 ) à DEL et
- sur une deuxième surface ( 102 ) principale de la plaquette ( 100 ) à circuit imprimé à âme métallique, opposée à la première surface ( 101 ) principale, est disposé un dispositif ( 3 ) de refroidissement,
**caractérisé en ce que**
- la plaquette ( 100 ) à circuit imprimé à âme métallique a, dans la partie de contacts ( 7 ) de connexion, une réglette ( 6 ) de raccordement, qui est disposée sur la première surface ( 101 ) principale, une ou plusieurs traversée ( 103 ) par laquelle ou par lesquelles la réglette ( 6 ) de raccordement est accessible à une réglette d'enfichage à partir de la deuxième surface ( 102 ) principale de la plaquette ( 100 ) à circuit imprimé à âme métallique, et
- la réglette ( 6 ) de raccordement est séparée, au moyen d'une couche ( 9 ) d'étanchéité, d'une manière étanche à la poussière de la partie dans laquelle se trouve les composants ( 2 ) à DEL.

3. Module de signalisation à DEL, suivant la revendication 1, dans lequel une feuille ( 8 ) conductrice de la chaleur et isolante du point de vue électrique est interposée entre la deuxième surface ( 12 ) principale de la plaquette ( 10 ) à circuit imprimé et le dispositif ( 3 ) de refroidissement.

4. Module de signalisation à DEL, suivant l'une des revendications précédentes, dans lequel un bord ( 13 ) faisant tout le tour de la plaquette ( 10 ) de circuit imprimé électrique est adapté dans une rainure ( 21 ) faisant le tour d'un support ( 20 ) de module et un élément ( 23 ) d'étanchéité, faisant le tour et étanche à la poussière, est interposé entre la plaquette ( 10 ) à circuit imprimé et une surface ( 22 ) de support de la rainure ( 21 ) pour la plaquette ( 10 ) à circuit imprimé.

5. Module de signalisation à DEL, suivant les revendications 3 et 4, dans lequel un bord faisant le tour de la feuille ( 8 ) conductrice de la chaleur est utilisé comme élément ( 23 ) d'étanchéité faisant le tour.

6. Module de signalisation à DEL, suivant l'une des revendications précédentes, dans lequel sur la première surface ( 11 ) principale de la plaquette ( 10 ) à circuit imprimé est disposée une lame ( 30 ) optique notamment un support de lentille, qui est assis sur une paroi ( 24 ) latérale du support ( 20 ) de module faisant le tour de la plaquette ( 10 ) à circuit imprimé, ou sur un bord de la plaquette ( 10 ) à circuit imprimé, faisant le tour de la multiplicité des composants ( 2 ) à DEL, et a avec cette paroi ou ce bord un joint de boîtier étanche à la poussière.

7. Module de signalisation à DEL, suivant la revendication 6, dans lequel la lame ( 30 ) optique a un bourrelet ( 31 ) faisant le tour enjambant la paroi ( 24 ) latérale de support ( 20 ) de module ou le côté frontal de la plaquette ( 10 ) à circuit imprimé et formant avec la paroi ( 24 ) latérale du support ( 20 ) de module ou avec le côté frontal de la plaquette ( 10 ) à circuit imprimé le joint ( 40 ) de boîtier étanche à la poussière.

8. Module de signalisation à DEL, suivant la revendication 7, dans lequel tant la paroi ( 24 ) latérale du support ( 20 ) de module ou le côté frontal de la plaquette ( 10 ) à circuit imprimé qu'également le côté ( 32 ) intérieur faisant le tour du bourrelet ( 31 ) est biseauté, le biseau ( 33 ) du bourrelet ( 31 ) étant plus raide que le biseau ( 25 ) de la paroi ( 24 ) latérale du support ( 20 ) de module ou du côté frontal de la plaquette à circuit imprimé et les deux biseaux ( 25, 33 ) étant pressés l'un sur l'autre et formant le joint ( 40 ) de boîtier étanche à la poussière.

9. Module de signalisation à DEL, suivant la revendication 6, 7 ou 8, dans lequel des sous-parties ( 35 ) du côté, tourné vers la plaquette ( 10 ) à circuit imprimé, de la lame ( 30 ) optique s'appliquent entre les composants ( 2 ) à DEL sur la première surface ( 11 ) principale de la plaquette ( 10 ) à circuit imprimé et repoussent la plaquette ( 10 ) à circuit imprimé sur la rainure ( 21 ) du support ( 20 ) de module.

10. Module de signalisation à DEL, suivant l'une des revendications 6 à 9, dans lequel le support ( 20 ) de module et la lame ( 30 ) optique sont en une matière plastique transparente.

11. Module de signalisation à DEL, suivant l'une des revendications 6 à 10, dans lequel un verre ( 60 ) de fermeture est monté en aval de la lame ( 30 ) optique dans la direction d'émission du module.

12. Module de signalisation à DEL, suivant l'une des revendications 6 à 11, dans lequel une vitre ( 70 ) de dispersion est montée en aval de la lame ( 30 ) optique dans la direction d'émission du module.

13. Module de signalisation à DEL, suivant l'une des revendications précédentes, dans lequel sur la plaquette ( 10 ) à circuit imprimé sensiblement seulement les composants ( 2 ) à DEL produisent, en fonctionnement du module, de la chaleur perdue sensible et d'autres composants produisant des pertes de chaleur, notamment un dispositif d'alimentation en énergie et/ou de commande, sont disposés dans une grande mesure en étant éloignés de la plaquette ( 10 ) à circuit imprimé.
